(19) Europäisches Patentamt
European Patent Office
Office européen des brevets

(11) **EP 4 131 431 A1**

(12) **EUROPEAN PATENT APPLICATION**
published in accordance with Art. 153(4) EPC

(43) Date of publication:
**08.02.2023 Bulletin 2023/06**

(21) Application number: **21816958.9**

(22) Date of filing: **17.05.2021**

(51) International Patent Classification (IPC):
**H01L 31/107** (1990.01)     **H01L 27/146** (1990.01)

(52) Cooperative Patent Classification (CPC):
**H01L 27/146; H01L 31/107**

(86) International application number:
**PCT/JP2021/018677**

(87) International publication number:
**WO 2021/246146 (09.12.2021 Gazette 2021/49)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **04.06.2020 JP 2020097598**

(71) Applicant: **Hamamatsu Photonics K.K.
Hamamatsu-shi, Shizuoka 435-8558 (JP)**

(72) Inventors:
• **TSUKADA Yoshinori
Hamamatsu-shi, Shizuoka 435-8558 (JP)**
• **KASAMORI Kohei
Hamamatsu-shi, Shizuoka 435-8558 (JP)**
• **HIROSE Masaki
Hamamatsu-shi, Shizuoka 435-8558 (JP)**
• **WARASHINA Yoshihisa
Hamamatsu-shi, Shizuoka 435-8558 (JP)**

(74) Representative: **Boult Wade Tennant LLP
Salisbury Square House
8 Salisbury Square
London EC4Y 8AP (GB)**

(54) **SEMICONDUCTOR LIGHT DETECTION ELEMENT**

(57) A photodetection element 10 includes a semiconductor substrate 16 having a principal surface 16a on which detection target light is incident and a rear surface 16b opposite to the principal surface 16a, and including one or a plurality of photodetection regions 11 on the principal surface 16a side each for generating a charge in an amount according to a light intensity of the detection target light, and a light absorption film 13 provided on the rear surface 16b of the semiconductor substrate 16. The light absorption film 13 includes a reflection layer 133 being a metal layer, a resonance layer 132 provided between the reflection layer 133 and the semiconductor substrate 16, and a light absorption layer 131 provided between the resonance layer 132 and the semiconductor substrate 16. In at least one of a wavelength of the detection target light and a wavelength of spontaneous light generated in the photodetection region 11, a light transmittance inside the resonance layer 132 is larger than a light transmittance inside the light absorption layer 131, and a light reflectance on a surface of the reflection layer 133 is larger than a light reflectance on a surface of the resonance layer 132. Thus, a semiconductor photodetection element capable of reducing reflection of light on a rear surface of a semiconductor substrate is realized.

Fig.1

**Description**

**Technical Field**

The present disclosure relates to a semiconductor photodetection element.

**Background Art**

Patent Document 1 discloses a technique related to a solid-state imaging element. The solid-state imaging element includes a sensor unit for performing photoelectric conversion formed on a front surface side of a semiconductor substrate. A low reflection film having low reflectance for infrared light is formed on a rear surface side of the semiconductor substrate. Patent Document 2 discloses a technique related to a silicon photomultiplier (SiPM). The SiPM includes a plurality of cells each including an avalanche photodiode.

**Citation List**

**Patent Literature**

Patent Document 1: Japanese Patent Application Laid-Open Publication No. 2007-305675
Patent Document 2: US Patent Application Publication No. 2013/0099100

**Summary of Invention**

**Technical Problem**

As a semiconductor photodetection element, there is an element in which a photodetection region such as a photodiode is formed on a front surface of a semiconductor substrate. In the semiconductor photodetection element, when detection target light is incident from the front surface side of the semiconductor substrate, a part of the light is not absorbed in the photodetection region and passes through the photodetection region. Further, the light is reflected on a rear surface of the semiconductor substrate, reaches the photodetection region again, and is absorbed by the photodetection region.

The above behavior of the detection target light causes the following problem. That is, compared to the detection target light which is absorbed immediately after being incident on the photodetection region, a delay occurs in the absorption timing of the detection target light which is reflected on the rear surface of the semiconductor substrate and then absorbed by the photodetection region. Therefore, a waveform of a detection signal obtained by amplifying the charge output from the photodetection region is temporally expanded, leading to a decrease in temporal resolution.

Further, in the case where the semiconductor photodetection element includes a plurality of pixels (or cells) each having the photodetection region, when the detection target light is reflected on the rear surface of the semiconductor substrate of a certain pixel (or cell) and then the detection target light is absorbed by the photodetection region of another adjacent pixel (or cell), crosstalk occurs between the adjacent pixels (adjacent cells). The above crosstalk may occur not only by the detection target light but also by light (spontaneous light) generated in the photodetection region. Therefore, in order to increase spatial resolution and temporal resolution of the semiconductor photodetection element, it is desirable to reduce reflection of light on the rear surface of the semiconductor substrate.

An object of the present invention is to provide a semiconductor photodetection element capable of reducing reflection of light on a rear surface of a semiconductor substrate.

**Solution to Problem**

An embodiment of the present invention is a semiconductor photodetection element. The semiconductor photodetection element includes a semiconductor substrate having a principal surface on which detection target light is incident and a rear surface opposite to the principal surface, and including one or a plurality of photodetection regions on the principal surface side each for generating a charge in an amount according to a light intensity of the detection target light; and a light absorption film provided on the rear surface of the semiconductor substrate, and the light absorption film has a multi-layer structure including a reflection layer being a metal layer, a resonance layer provided between the reflection layer and the semiconductor substrate, and a light absorption layer provided between the resonance layer and the semiconductor substrate, and in at least one of a wavelength of the detection target light and a wavelength of spontaneous light generated in the photodetection region, a light transmittance inside the resonance layer is larger than a light transmittance inside the light absorption layer, and a light reflectance on a surface of the reflection layer is larger than a light reflectance on a surface of the resonance layer.

In the above semiconductor photodetection element, a charge of an amount according to the light intensity of the detection target light incident from the principal surface of the semiconductor substrate is generated in the photodetection region. Thus, an incident light amount of the detection target light can be electrically detected. The detection target light which is not absorbed in the photodetection region reaches the light absorption film provided on the rear surface of the semiconductor substrate. When the spontaneous light is generated in the photodetection region, the spontaneous light also reaches the light absorption film.

The light absorption film of the semiconductor photodetection element has the multi-layer structure including the reflection layer, the resonance layer, and the light absorption layer. A part of the light incident on the light absorption film is immediately absorbed in the light absorption layer. Light which is not absorbed by the light absorption layer passes through the light absorption layer and enters the resonance layer. Further, the light entering the resonance layer is gradually absorbed by the light absorption layer while being multiply reflected between an interface between the light absorption layer and the resonance layer and an interface between the resonance layer and the reflection layer.

Thus, according to the above light absorption film, extremely high absorption efficiency can be realized as compared with a light absorption film of a single layer. Therefore, according to the above semiconductor photodetection element, reflection of light on the rear surface of the semiconductor substrate can be effectively reduced, and thus, a decrease in temporal resolution can be suppressed, and crosstalk between adjacent pixels (adjacent cells) can be reduced.

**Advantageous Effects of Invention**

According to the semiconductor photodetection element of the embodiment of the present invention, it is possible to reduce reflection of light on a rear surface of a semiconductor substrate.

Brief Description of Drawings

[FIG. 1] FIG. 1 is a partial cross-sectional view of a photodetection device according to an embodiment.
[FIG. 2] FIG. 2 is a schematic plan view of a semiconductor photodetection element included in the photodetection device.
[FIG. 3] FIG. 3 is a circuit diagram of the photodetection device.
[FIG. 4] FIG. 4 includes (a) - (c) diagrams for describing a manufacturing process of the photodetection device according to the embodiment.
[FIG. 5] FIG. 5 includes (a) - (c) diagrams for describing the manufacturing process of the photodetection device according to the embodiment.
[FIG. 6] FIG. 6 includes (a), (b) diagrams for describing the manufacturing process of the photodetection device according to the embodiment.
[FIG. 7] FIG. 7 includes (a), (b) diagrams for describing the manufacturing process of the photodetection device according to the embodiment.
[FIG. 8] FIG. 8 is a diagram schematically illustrating a cross-sectional configuration of a layered structure prepared for verification.
[FIG. 9] FIG. 9 is a diagram schematically illustrating a cross-sectional configuration of a layered structure prepared for verification.
[FIG. 10] FIG. 10 is a graph schematically showing a voltage signal waveform including crosstalk.
[FIG. 11] FIG. 11 is a graph showing an example in which a sample is placed in a dark box and a dark count rate is measured by changing a threshold of a comparator.
[FIG. 12] FIG. 12 is a graph showing a relationship between a reverse bias voltage and a crosstalk probability in each sample in the example.
[FIG. 13] FIG. 13 is a graph showing a dark current property caused by spontaneous light in each sample in the example.
[FIG. 14] FIG. 14 is a diagram schematically illustrating a cross-sectional configuration of a light absorption film.
[FIG. 15] FIG. 15 is a diagram schematically illustrating a configuration in which the light absorption film is disposed on a rear surface of a semiconductor substrate.
[FIG, 16] FIG. 16 is a partial cross-sectional view illustrating a configuration of a photodetection element according to a first modification.

[FIG. 17] FIG. 17 is a partial cross-sectional view illustrating a configuration of a photodetection element according to a second modification.

[FIG. 18] FIG. 18 is a partial cross-sectional view illustrating a configuration of a photodetection element according to a third modification.

[FIG. 19] FIG. 19 is a partial cross-sectional view illustrating a configuration of a photodetection element according to a fourth modification.

[FIG. 20] FIG 20 is a partial cross-sectional view illustrating a configuration of a photodetection element according to a fifth modification.

[FIG. 21] FIG. 21 is a partial cross-sectional view illustrating a configuration of a photodetection element according to a sixth modification.

[FIG. 22] FIG. 22 is a partial cross-sectional view illustrating a configuration of a photodetection element according to a seventh modification.

[FIG. 23] FIG. 23 is a partial cross-sectional view illustrating a configuration of a photodetection element according to an eighth modification.

[FIG. 24] FIG. 24 is a partial cross-sectional view illustrating a configuration of a photodetection element according to a ninth modification.

**Description of Embodiments**

Hereinafter, embodiments of a semiconductor photodetection element will be described in detail with reference to the accompanying drawings. In addition, in the description of the drawings, the same elements will be denoted by the same reference signs, and redundant description will be omitted. The present invention is not limited to these examples.

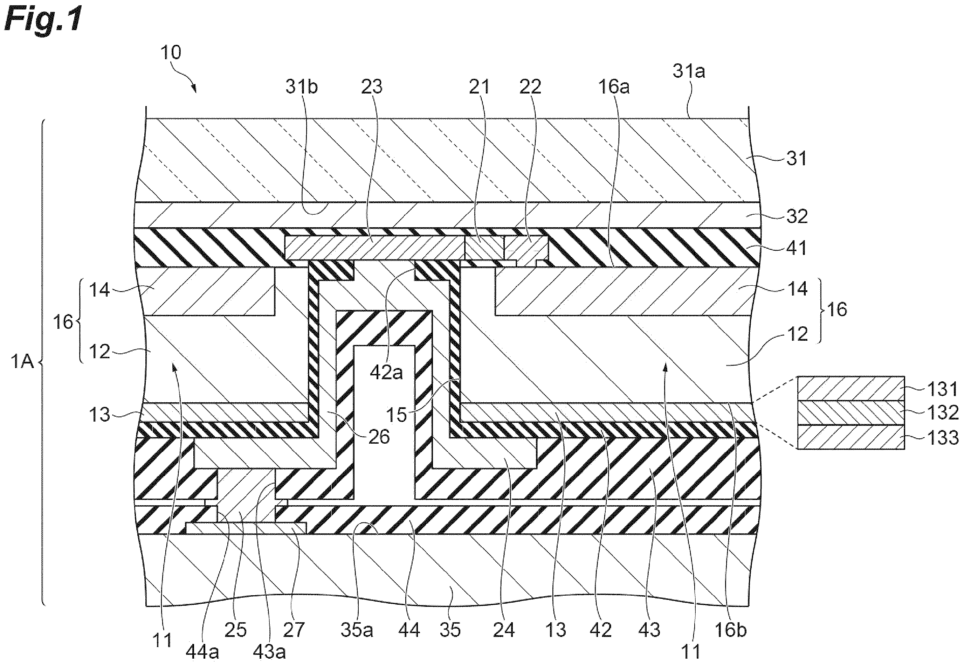

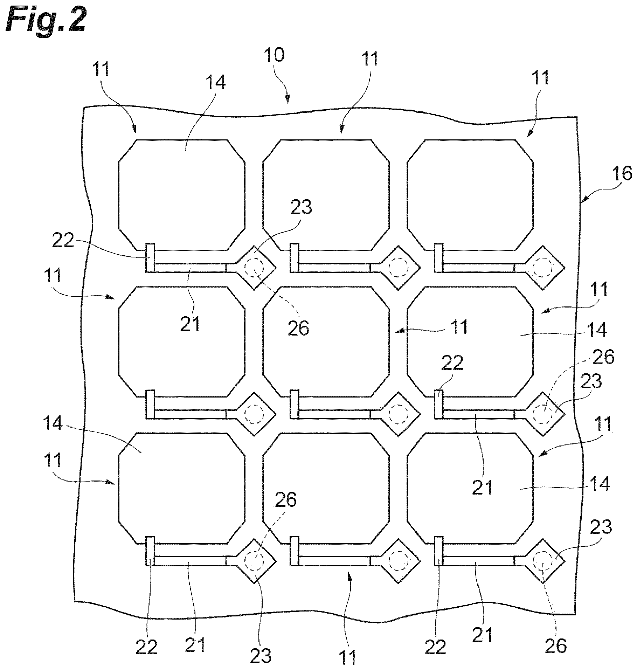

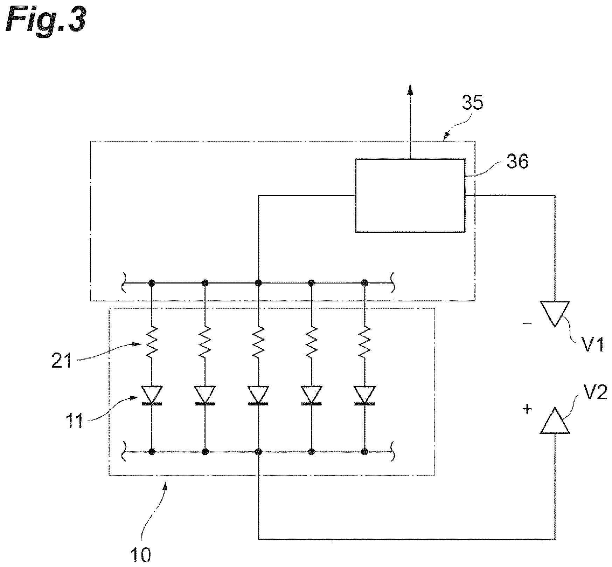

FIG. 1 is a partial cross-sectional view of a photodetection device 1A according to the present embodiment. FIG. 2 is a schematic plan view of a semiconductor photodetection element (hereinafter, simply referred to as a photodetection element) 10 included in the photodetection device 1A. FIG. 3 is a circuit diagram of the photodetection device 1A.

As illustrated in FIG 1, the photodetection device 1A includes a photodetection element 10, a glass substrate 31, and a mounting substrate 35. The mounting substrate 35 is disposed to face the photodetection element 10. The glass substrate 31 is disposed to face the photodetection element 10. The photodetection element 10 is disposed between the mounting substrate 35 and the glass substrate 31.

The photodetection element 10 of the present embodiment is a photodiode array. The photodetection element 10 includes a semiconductor substrate 16 having a rectangular shape in a planar view. The semiconductor substrate 16 includes a principal surface 16a and a rear surface 16b being opposite to each other. Detection target light is incident on the principal surface 16a. In one example, the semiconductor substrate 16 is a Si substrate or an InP substrate. A thickness of the semiconductor substrate 16 (distance between the principal surface 16a and the rear surface 16b) is, for example, 1 $\mu$m or more and 1000 $\mu$m or less.

The photodetection element 10 includes a plurality of photodetection regions 11 formed in the semiconductor substrate 16. Each of the photodetection regions 11 generates a charge in an amount according to a light intensity of the detection target light. A quenching resistor 21 is connected in series to each photodetection region 11. One photodetection region 11 constitutes one cell in the photodetection element 10.

The respective photodetection regions 11, each being connected in series with the quenching resistor 21, are connected in parallel, and a reverse bias voltage is applied from a power source. An output current from the photodetection region 11 is detected by a signal processing unit 36 described later. In FIG. 2, for clarifying the configuration, an insulating film 41 illustrated in FIG. 1 is omitted.

Each photodetection region 11 includes a semiconductor region 14 of a second conductivity type (for example, p-type). The semiconductor region 14 is formed on the principal surface 16a side of the semiconductor substrate 16. A planar shape of the semiconductor region 14 is, for example, a polygonal shape (octagonal shape in the present embodiment). Further, the semiconductor substrate 16 includes a semiconductor region 12 of a first conductivity type (for example, n-type). The semiconductor region 12 forms a region in the semiconductor substrate 16 excluding the semiconductor region 14.

As illustrated in FIG. 2, the photodetection region 11 includes an electrode 22 and an electrode 23 which are respectively disposed on the principal surface 16a side of the semiconductor substrate 16. The electrode 22 is electrically connected to the semiconductor region 14. The electrode 23 is formed on the semiconductor substrate 16 outside the semiconductor region 14 via the insulating film 41 when viewed from the principal surface 16a side. Further, the photodetection region 11 includes an electrode (not shown) electrically connected to the semiconductor substrate 16 and an electrode 24 which are respectively disposed on the rear surface 16b side of the semiconductor substrate 16. The electrode 24 is formed on the rear surface 16b of the semiconductor substrate 16 via an insulating film 42.

The photodetection element 10 includes the quenching resistor 21, for each photodetection region 11, formed on the semiconductor substrate 16 outside the semiconductor region 14 via the insulating film 41. That is, the quenching resistor 21 is disposed on the principal surface 16a side of the semiconductor substrate 16. One end of the quenching resistor 21 is connected to the electrode 22, and the other end is connected to the electrode 23. The quenching resistor 21 has a higher resistivity than the electrode 22 to which it is connected. The quenching resistor 21 is made of, for example, polysilicon. A chemical vapor deposition (CVD) method can be used as a method of forming the quenching resistor 21.

The photodetection element 10 includes a plurality of through electrodes 26. The through electrode 26 is provided for each photodetection region 11. The through electrode 26 is formed to penetrate between the principal surface 16a and the rear surface 16b. That is, the through electrode 26 is disposed in a through hole 15 provided through the semiconductor substrate 16. An inner side surface of the through hole 15 extends in a thickness direction of the semiconductor substrate 16 (that is, a direction perpendicular to the principal surface 16a and the rear surface 16b).

The insulating film 42 is formed also in the through hole 15. The through electrode 26 is disposed on the inner side surface and a bottom surface of the through hole 15 with the insulating film 42 interposed therebetween. One end of the through electrode 26 is connected to the electrode 23, and is electrically connected to the semiconductor region 14 of the photodetection region 11 via the electrode 23, the quenching resistor 21, and the electrode 22. The other end of the through electrode 26 is connected to the electrode 24.

The through electrode 26 is disposed in a region between the photodetection regions 11 in a planar view. In the present embodiment, the photodetection regions 11 are arranged two-dimensionally in M rows in a first direction and in N columns in a second direction perpendicular to the first direction (each of M and N is a natural number). The through electrode 26 is formed in a region surrounded by the four photodetection regions 11. The through electrode 26 is provided for each photodetection region 11, and thus, the through electrodes 26 are arranged two-dimensionally in M rows in the first direction and in N columns in the second direction.

The electrodes 22, 23, 24 and the through electrode 26 are made of metal. Examples of the metal used for the electrodes 22, 23, 24 and the through electrode 26 include a single-layer film such as Al, Ti, Cu, Ni, or AlCu, and a multi-layer film such as Al/Ni, Al/Ti/Cu, Ti/Cu, Ti/Cu/Ni, or Ti/Cu/Ti. In addition, a notation A/B/C represents that an A layer, a B layer, and a C layer are stacked in this order from the semiconductor substrate 16 side.

When the semiconductor substrate 16 is an InP substrate, AuGe/Ni or the like is also often used as the electrode material. Depending on the process design, the electrode 24 and the through electrode 26 may be integrally formed. As a method of forming the electrodes 22, 23, 24 and the through electrode 26, a sputtering method can be used.

In the case of using Si, a group III element such as B is used as a p-type impurity, and a group V element such as N, P or As is used as an n-type impurity. The n-type and the p-type, which are conductivity types of the semiconductor, may be replaced with each other to form the device, and the device may function. As a method of adding these impurities, a diffusion method or an ion implantation method can be used.

As a material of the insulating films 41 and 42, an insulating silicon compound such as $SiO_2$, SiN, or SiON, an insulating metal oxide such as $Al_2O_3$ or $TiO_2$, or an insulating resin can be used. As a method of forming the insulating films 41 and 42, when the insulating films 41 and 42 are made of $SiO_2$, a thermal oxidation method or a CVD method can be used.

In the case of the configuration described above, a p-n junction is formed between the n-type semiconductor region 12 and the p-type semiconductor region 14, thereby forming a photodiode (for example, an avalanche photodiode) as the photodetection region 11. The semiconductor region 12 is electrically connected to the electrode (not shown) formed on the rear surface 16b side, and the semiconductor region 14 is electrically connected to the electrode 22. The quenching resistor 21 is connected in series to the photodetection region 11 (see FIG. 3).

When each photodetection region 11 is an avalanche photodiode, each of the photodetection regions 11 is operated in Geiger mode. In Geiger mode, a reverse voltage (reverse bias voltage) larger than a breakdown voltage of the photodetection region 11 is applied between an anode and a cathode of the photodetection region 11. That is, a negative potential V1 is applied to the anode, and a positive potential V2 is applied to the cathode. The polarities of these potentials are relative, and one of the potentials may be set to a ground potential. The anode is the p-type semiconductor region 14, and the cathode is the n-type semiconductor region 12.

When photons of the detection target light are incident on the photodetection region 11, photoelectric conversion is performed inside the semiconductor substrate 16, and photoelectrons are generated. Avalanche multiplication is performed in a region near the p-n junction interface of the semiconductor region 14, and amplified carriers flow toward the electrode 22 formed on the principal surface 16a of the semiconductor substrate 16. That is, when a photon enters any cell (photodetection region 11) of the photodetection element 10, electron multiplication is performed after photoelectric conversion, and a current signal is output from the electrode 24.

The photodetection element 10 includes a light absorption film 13. The light absorption film 13 is provided on the rear surface 16b of the semiconductor substrate 16, and is disposed between the rear surface 16b of the semiconductor substrate 16 and the insulating film 42. The light absorption film 13 is provided for absorbing the detection target light being transmitted without being absorbed by the photodetection region 11 and/or the spontaneous light generated in the photodetection region 11. The light absorption film 13 has a multi-layer structure including a light absorption layer 131, a resonance layer 132, and a reflection layer 133.

The light absorption layer 131 is provided between the resonance layer 132 and the semiconductor substrate 16. A thickness of the light absorption layer 131 is within a range of several nm to several μm. The resonance layer 132 is provided between the reflection layer 133 and the semiconductor substrate 16, specifically, between the reflection layer 133 and the light absorption layer 131. A thickness of the resonance layer 132 is within a range of several nm to several hundred μm.

In one example, an optical thickness of the resonance layer 132 is an integer multiple of 1/4 of a wavelength $\lambda_1$ of the detection target light or a wavelength $\lambda_2$ of the spontaneous light generated in the photodetection region 11. Further, the optical thickness of the resonance layer 132 may be within a range of ±20% centered on the integer multiple of $\lambda_1/4$ or $\lambda_2/4$. The wavelength $\lambda_1$ of the detection target light is within a range from a visible range to a near infrared range, and is, for example, 350 nm or more and 1200 nm or less. When the photodetection region 11 is the avalanche photodiode, the wavelength $\lambda_2$ of the spontaneous light generated in the photodetection region 11 is, for example, 700 nm or more and 1100 nm or less. A thickness of the reflection layer 133 is within a range of several tens of nm to several mm.

Further, in at least one of the wavelengths $\lambda_1$ and $\lambda_2$, a light transmittance inside the resonance layer 132 is larger than a light transmittance inside the light absorption layer 131. In other words, an extinction coefficient of the resonance layer 132 is smaller than an extinction coefficient of the light absorption layer 131. The light absorption layer 131 is made of, for example, metal. The metal constituting the light absorption layer 131 may contain one or more materials selected from the group consisting of tungsten silicide ($WSi_x$), Ti, TiN, and Cr. In one example, the light absorption layer 131 mainly contains tungsten silicide, and in one example, is made of tungsten silicide.

The resonance layer 132 mainly contains, for example, a silicon compound such as $SiO_2$, SiN, or SiON, and in one example, is made of $SiO_2$, SiN, or SiON. In at least one of the wavelengths $\lambda_1$ and $\lambda_2$, the resonance layer 132 may have a light transmitting property. In addition, the feature "having a light transmitting property" refers to being transparent for the target wavelength, that is, having a light transmittance of 70% or more.

Further, in at least one of the wavelengths $\lambda_1$ and $\lambda_2$, a light reflectance on the surface of the reflection layer 133 is larger than a light reflectance on the surface of the resonance layer 132. In addition, in the present embodiment, the "light reflectance on the surface of the reflection layer" refers to the light reflectance on the surface on the resonance layer side of the reflection layer, and the "light reflectance on the surface of the resonance layer" refers to the light reflectance on the surface on the light absorption layer side of the resonance layer.

The reflection layer 133 is a metal layer. The metal constituting the reflection layer 133 may contain one or more materials selected from the group consisting of Al, an Al-based alloy (AlCu, AlSi, or the like), Cu, Ag, and Au. In one example, the reflection layer 133 mainly contains Al, and in one example, is made of Al.

As illustrated in FIG. 1, the mounting substrate 35 includes a planar principal surface 35a. The mounting substrate 35 has a rectangular shape in a planar view. The principal surface 35a faces the rear surface 16b of the semiconductor substrate 16. The mounting substrate 35 includes a plurality of electrodes 27 disposed on the principal surface 35a. The electrode 27 is provided corresponding to the through electrode 26. Specifically, the electrode 27 is formed on each region facing the electrode 24 on the principal surface 35a.

The electrode 24 and the electrode 27 are connected by a bump electrode 25. Thus, the through electrode 26 is electrically connected to the electrode 27 via the electrode 24 and the bump electrode 25. Further, the quenching resistor 21 is electrically connected to the electrode 27 via the electrode 23, the through electrode 26, the electrode 24, and the bump electrode 25. The electrode 27 is made of the same metal as the electrodes 22, 23, 24 and the through electrode 26. The bump electrode 25 mainly contains, for example, solder.

The mounting substrate 35 includes the signal processing unit 36 illustrated in FIG. 3. That is, the mounting substrate 35 constitutes an application specific integrated circuit (ASIC). Each electrode 27 is electrically connected to the signal processing unit 36 via a wiring line (not shown) formed in the mounting substrate 35. The output signal from each photodetection region 11 is input to the signal processing unit 36, and the signal processing unit 36 processes the output signal from each photodetection region 11.

The signal processing unit 36 includes a CMOS circuit which converts the output signal from each photodetection region 11 into a digital pulse. Further, the mounting substrate 35 is configured to include a circuit for recording time information corresponding to each cell (photodetection region 11). As the circuit for recording the time information, a time-to-digital converter (TDC), a time-to-amplitude converter (TAC), or the like may be used. Accordingly, a difference in wiring distance in the mounting substrate 35 does not affect temporal resolution.

A passivation film 43 in which an opening 43a is formed at a position corresponding to the bump electrode 25 is disposed on the rear surface 16b of the semiconductor substrate 16. A passivation film 44 in which an opening 44a is formed at a position corresponding to the bump electrode 25 is disposed on the principal surface 35a of the mounting substrate 35.

The passivation films 43 and 44 are formed of, for example, a resin insulating film such as a polyimide-based film, a phenol-based film, or an epoxy-based film, a $SiO_2$/resin insulating film, a SiN/resin insulating film, a SiON/resin insulating film, a $SiO_2$ film, a SiN film, or a SiON film. As a method of forming the passivation films 43 and 44, a spin coating method can be used in the case of the resin insulating film, and a chemical vapor deposition (CVD) method can be used in the case of the $SiO_2$ film.

The glass substrate 31 includes a principal surface 31a and a rear surface 31b being opposite to each other. The glass substrate 31 has a rectangular shape in a planar view. The rear surface 31b faces the principal surface 16a of the semiconductor substrate 16. The principal surface 31a and the rear surface 31b are flat. The glass substrate 31 and the photodetection element 10 are bonded and optically coupled by an optical adhesive 32. The glass substrate 31 may be directly formed on the photodetection element 10.

A scintillator (not shown) may be optically coupled to the principal surface 31a of the glass substrate 31 via another optical adhesive. Scintillation light from the scintillator passes through the glass substrate 31 as the detection target light and is incident on the photodetection element 10.

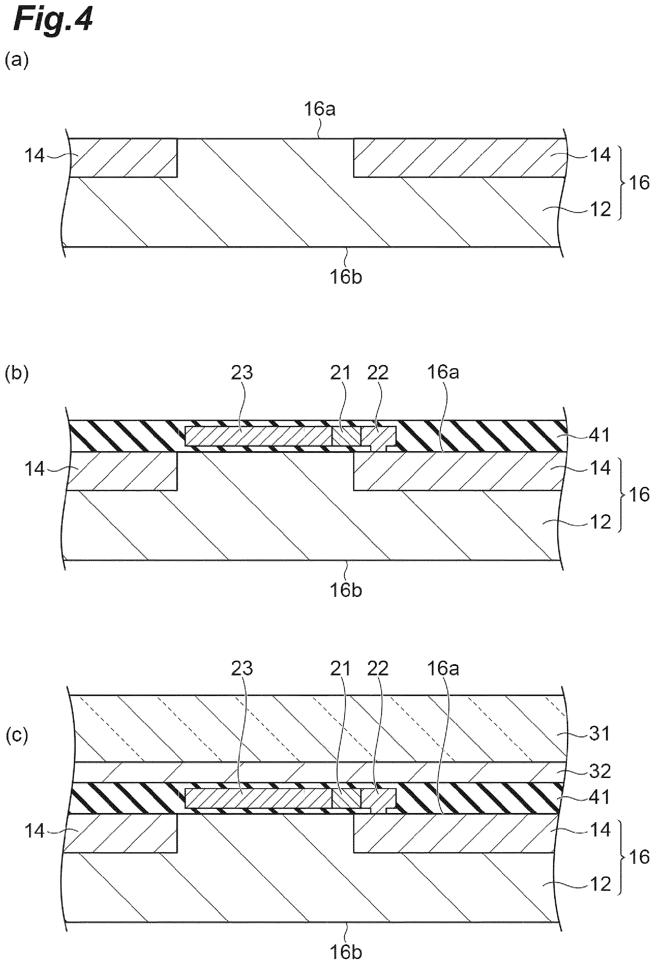

Next, a method of manufacturing the photodetection device 1A described above will be described with reference to FIG. 4 to FIG. 7. FIG. 4 to FIG. 7 include diagrams for describing a manufacturing process of the photodetection device 1A according to the present embodiment.

First, as illustrated in (a) in FIG. 4, the semiconductor substrate 16 having the semiconductor regions 12 and 14 is formed. In this step, for example, a semiconductor substrate of the first conductivity type is prepared, and ion implantation is performed from the principal surface side of the semiconductor substrate to form a plurality of semiconductor regions 14 of the second conductivity type. In this case, a region excluding the semiconductor regions 14 becomes the semiconductor region 12.

Next, as illustrated in (b) in FIG. 4, the quenching resistor 21, the electrodes 22 and 23, and the insulating film 41 are formed on the principal surface 16a of the semiconductor substrate 16. In this step, first, a lower layer part of the insulating film 41 is formed. Thereafter, an opening is formed in a portion of the lower layer part of the insulating film 41 located on the semiconductor region 14, and then the quenching resistor 21 and the electrodes 22 and 23 are formed on the lower layer part of the insulating film 41. In this case, the electrode 22 is connected to the semiconductor region 14 via the opening. Further, an upper layer part of the insulating film 41 is formed to cover the quenching resistor 21 and the electrodes 22 and 23 by the upper layer part.

Subsequently, as illustrated in (c) in FIG. 4, the glass substrate 31 and the insulating film 41 are bonded to each other with the optical adhesive 32 interposed therebetween. As a result, the glass substrate 31 and the photodetection element 10 are optically coupled to each other. Subsequently, the rear surface 16b of the semiconductor substrate 16 is polished to thin the semiconductor substrate 16. In this step, the semiconductor substrate 16 is thinned by using, for example, a mechanical polishing method or a chemical polishing method.

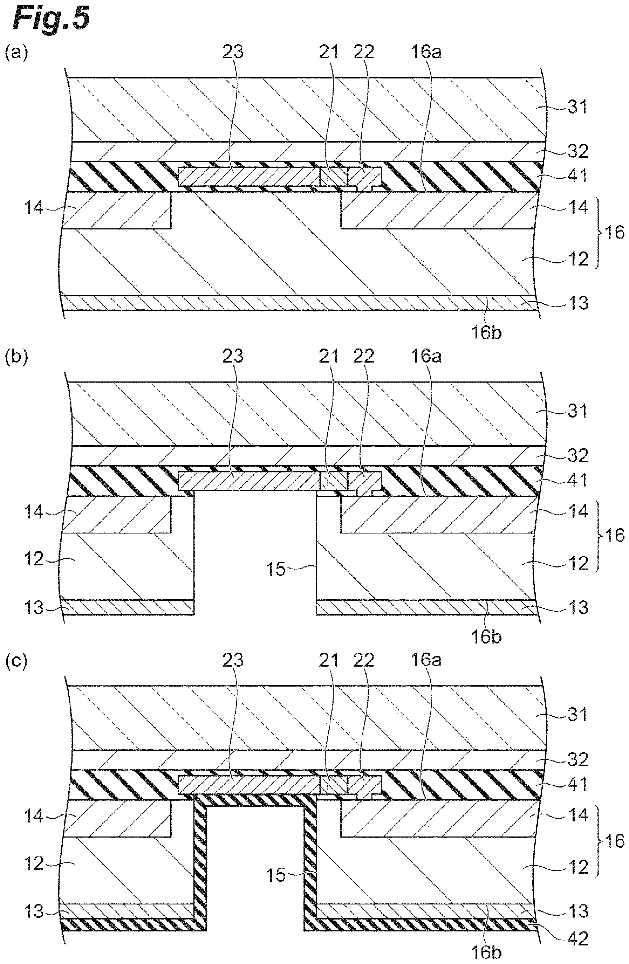

Further, as illustrated in (a) in FIG. 5, the light absorption film 13 is formed on the rear surface 16b of the semiconductor substrate 16. In one example, the light absorption layer 131 (for example, $WSi_x$) is formed by sputtering, the resonance layer 132 (for exmaple, $SiO_2$) is formed by CVD, and the reflection layer 133 (for example, AlCu) is formed by sputtering.

Subsequently, as illustrated in (b) in FIG. 5, the through hole 15 is formed in the light absorption film 13 and the semiconductor substrate 16. In this step, for example, the through hole 15 is formed by appropriately selecting a dry etching method and a wet etching method, and the etching is stopped when the electrode 23 is exposed. In addition, the light absorption film 13 may be formed after forming the through hole 15.

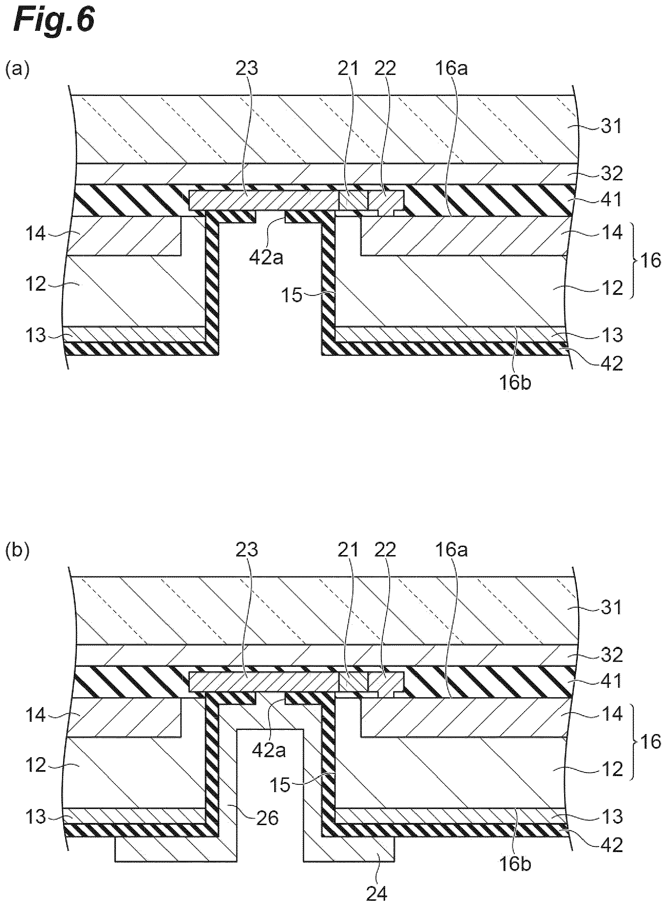

Subsequently, as illustrated in (c) in FIG. 5, the insulating film 42 is formed on the rear surface 16b of the semiconductor substrate 16 (on the light absorption film 13) and on the inner side surface and on the bottom surface (on the electrode 23) of the through hole 15. Further, as illustrated in (a) in FIG. 6, the opening 42a is formed in a portion of the insulating film 42 being located on the bottom surface of the through hole 15 (on the electrode 23). In this step, the opening 42a is formed by, for example, etching the insulating film 42 until the electrode 23 is exposed.

Subsequently, as illustrated in (b) in FIG. 6, a metal film is formed on the inner side surface and the bottom surface of the through hole 15 and on a region of the rear surface 16b located around the through hole 15. As a result, the through electrode 26 is formed on the inner side surface and the bottom surface of the through hole 15, and the electrode 24 is formed on the rear surface 16b.

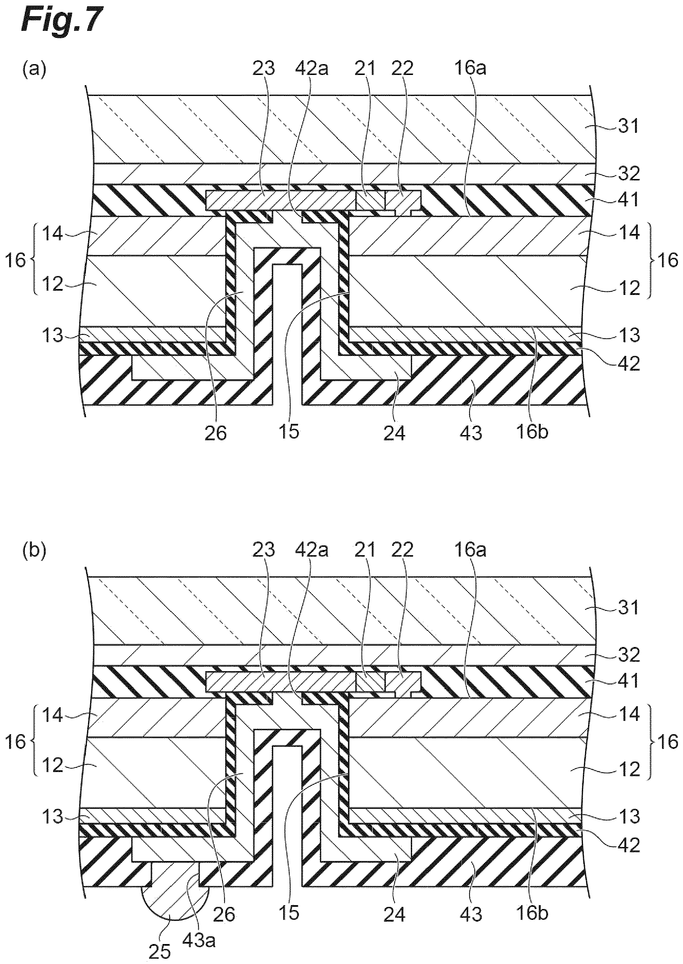

Subsequently, as illustrated in (a) in FIG. 7, the passivation film 43 is formed on the rear surface 16b of the semiconductor substrate 16 and in the through hole 15, and the electrode 24 and the through electrode 26 are covered by the passivation film 43. Further, as illustrated in (b) in FIG. 7, the opening 43a is formed by etching in a portion of the passivation film 43 located on the electrode 24. Thereafter, the bump electrode 25 covering the opening 43a is formed.

In addition, prior to the formation of the bump electrode 25, an under bump metal (UBM) is formed in a region of the electrode 24 exposed from the passivation film 43. The UBM is made of a material having excellent electrical and physical connection with the bump electrode 25. As a method of forming the UBM, an electroless plating method can be used. As a method of forming the bump electrode 25, a method of mounting a solder ball or a printing method can be used.

Subsequently, the photodetection element 10 and the separately prepared mounting substrate 35 are bump-connected to each other (see FIG. 1). Further, a layered structure including the glass substrate 31, the photodetection element 10, and the mounting substrate 35 is cut by dicing into individual pieces. Through the above steps, the photodetection device 1A of the present embodiment is formed. In addition, after the layered structure including the glass substrate 31 and the photodetection element 10 is divided into individual pieces by dicing, the photodetection element 10 of the layered structure and the mounting substrate 35 may be bump-connected to each other.

The function and effect obtained by the photodetection element 10 according to the present embodiment described above will be described. In the photodetection element 10 of the present embodiment, a charge of an amount according to a light intensity of the detection target light incident from the principal surface 16a of the semiconductor substrate 16 is generated in the photodetection region 11. Thus, an incident light amount of the detection target light can be electrically detected. The detection target light which is not absorbed in the photodetection region 11 reaches the light absorption film 13 provided on the rear surface 16b of the semiconductor substrate 16. When the spontaneous light is generated in the photodetection region 11, the spontaneous light also reaches the light absorption film 13.

The light absorption film 13 has the multi-layer structure including the light absorption layer 131, the resonance layer 132, and the reflection layer 133. A part of the light incident on the light absorption film 13 is immediately absorbed by the light absorption layer 131. Light which is not absorbed by the light absorption layer 131 passes through the light absorption layer 131 and enters the resonance layer 132. Further, the light entering the resonance layer 132 is gradually absorbed by the light absorption layer 131 while being multiply reflected between the interface between the light absorption layer 131 and the resonance layer 132 and the interface between the resonance layer 132 and the reflection layer 133.

Thus, according to the light absorption film 13 described above, it is possible to realize extremely high absorption efficiency as compared with a light absorption film of a single layer. Therefore, according to the photodetection element 10 of the present embodiment, reflection of light on the rear surface 16b of the semiconductor substrate 16 can be effectively reduced, and thus, it is possible to suppress a decrease in temporal resolution, and further, it is possible to reduce crosstalk between adjacent cells.

As described above, the optical thickness of the resonance layer 132 may be within a range of $\pm 20\%$ centered on an integer multiple of a quarter of the wavelength $\lambda_1$ of the detection target light or the wavelength $\lambda_2$ of the spontaneous light generated in the photodetection region 11 (that is, $\lambda_1/4$ or $\lambda_2/4$).

In this case, a phase of the light reflected by the interface between the light absorption layer 131 and the resonance layer 132 and a phase of the light reflected by the interface between the resonance layer 132 and the reflection layer 133 are shifted from each other by nearly $\pi$ (rad), and thus, they cancel out each other. Therefore, the absorption efficiency (extinction efficiency) of the light absorption film 13 can be further increased.

As described above, the photodetection region 11 may be an avalanche photodiode or a p-n junction type photodiode. For example in the above case, a charge in an amount according to the light intensity of the detection target light can be generated in the photodetection region 11.

Further, in particular, when the photodetection region 11 is the avalanche photodiode, the spontaneous light (secondary photon) is generated in the photodetection region 11. In the photodetection element 10 of the present embodiment, by appropriately designing the light absorption film 13, crosstalk due to the spontaneous light generated in the photodetection region 11 can also be reduced. Therefore, the photodetection element 10 of the present embodiment is particularly effective when the photodetection region 11 is the avalanche photodiode.

As in the present embodiment, the photodetection element 10 may include the through electrode 26 provided between the principal surface 16a and the rear surface 16b, and having one end on the principal surface 16a side electrically connected to the photodetection region 11. In this case, the mounting substrate 35 can be disposed on the rear surface 16b opposite to the principal surface 16a on which the detection target light is incident, and thus, even when a large number of photodetection regions 11 are arranged two-dimensionally in the principal surface 16a, the charge (output current) from each photodetection region 11 can be easily extracted.

Further, it is not necessary to provide wiring lines such as bonding wires for electrically connecting to the mounting substrate 35 on the principal surface 16a side, and thus, the fill factor of the photodetection element 10 can be increased. In other words, the size of the photodetection element 10 can be reduced, and the element can be placed in a small package.

Further, in order to improve the ease of forming the through electrode 26, it is preferable to make the semiconductor substrate 16 thin (see (a) in FIG. 5). However, in this case, a distance between the light incident surface (principal surface 16a) and the rear surface 16b of the semiconductor substrate 16 becomes small, and thus, temporal resolution is likely to be reduced and crosstalk between adjacent cells is likely to occur. According to the photodetection element 10 of the present embodiment, it is possible to suppress a decrease in temporal resolution and reduce crosstalk between the adjacent cells, and thus, it is particularly effective in the case where the through electrode 26 is provided in the semiconductor substrate 16.

As in the present embodiment, the photodetection element 10 may be bonded to the glass substrate 31. In this case, the mechanical strength of the semiconductor substrate 16 is allowed to be lower, and thus, it is possible to make the semiconductor substrate 16 thinner. Therefore, the through hole 15 can be easily formed, and response characteristics of the photodetection element 10 can be improved.

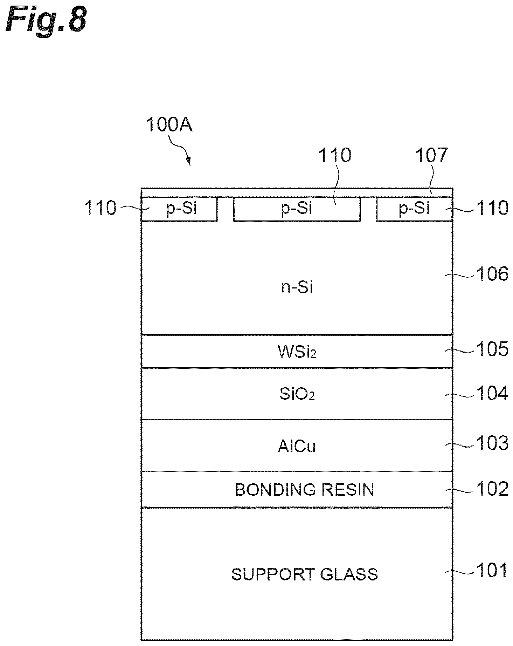

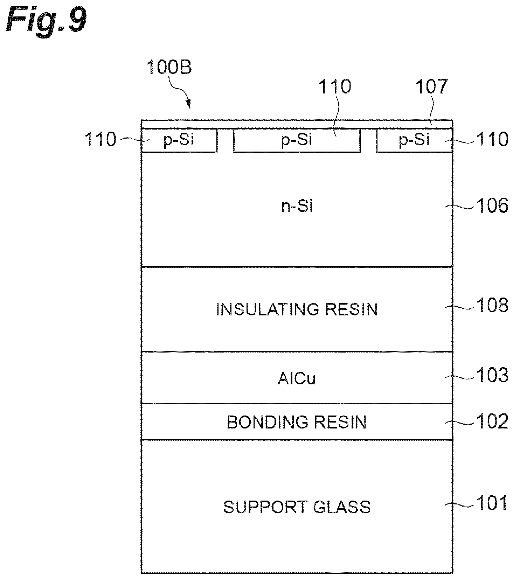

An example for verifying the crosstalk reduction effect according to the present embodiment will be described. FIG. 8 and FIG. 9 are diagrams schematically illustrating cross-sectional configurations of layered structures 100A and 100B prepared for the verification.

As illustrated in FIG. 8, the layered structure 100A has a configuration in which a bonding resin 102, an alloy layer 103 of Al and Cu, a $SiO_2$ layer 104 formed by a CVD method, a WSi layer 105, a Si layer 106, and a $SiO_2$ layer 107 are stacked in this order on a support glass 101. The WSi layer 105, the $SiO_2$ layer 104, and the alloy layer 103 respectively correspond to the light absorption layer 131, the resonance layer 132, and the reflection layer 133 of the present embodiment. The Si layer 106 corresponds to the semiconductor substrate 16 of the present embodiment. As illustrated in FIG. 9, the layered structure 100B has a configuration in which the bonding resin 102, the alloy layer 103 of Al and Cu, a resin insulating layer (phenolic resin) 108, the Si layer 106, and the $SiO_2$ layer 107 are stacked in this order on the support glass 101.

In the layered structures 100A and 100B, a thickness of the support glass 101 is set to 300 $\mu$m, a thickness of the bonding resin 102 is set to 10 $\mu$m, a thickness of the alloy layer 103 is set to 1000 nm, a thickness of the $SiO_2$ layer 104 is set to 100 nm, a thickness of the WSi layer 105 is set to 23 nm, and a thickness of the resin insulating layer 108 is set to 5000 nm. Further, a thickness of the Si layer 106 is changed within a range of 20 $\mu$m to 70 $\mu$m to form a plurality of samples for each of the layered structures 100A and 100B.

Further, the semiconductor regions 110 as a plurality of cells (photodetection regions) arranged two-dimensionally in 26 rows and 26 columns and wiring lines (not shown) are formed in the Si layer 106 of each layered structure. The semiconductor region 110 corresponds to the semiconductor region 14 of the present embodiment. A size of each cell is set to 50 $\mu$m for each side. Further, the quenching resistor is formed for each cell to collectively output the charges. The output charge is converted into a voltage signal by a wideband amplifier, a pulse having a height of a threshold or more is extracted by a comparator, and the number of pulses is counted by a counter circuit.

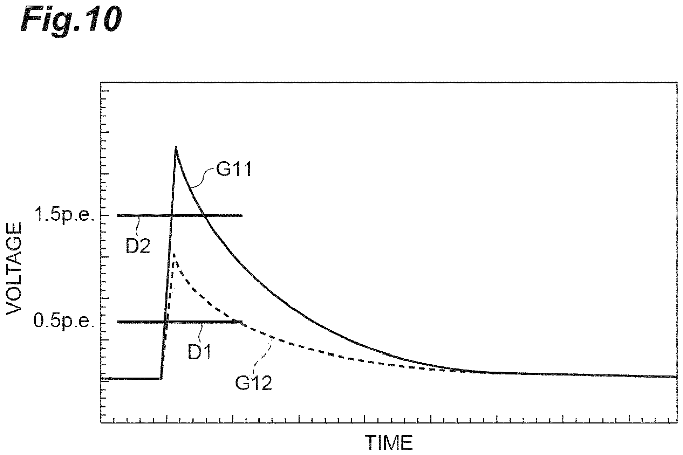

FIG. 10 is a graph schematically showing a voltage signal waveform including crosstalk. When one photon is detected in each sample described above, a pulse signal G12 having a height corresponding to one photon is output. In addition, the pulse height of one photon is defined as one photon equivalent (p.e.). When crosstalk occurs between the adjacent cells, a pulse signal G11 having a height of two photons (or more) appears in the voltage signal waveform in addition to the pulse signal G12 having a height of one photon.

When the threshold of the comparator for the voltage signal is set to, for example, 0.5 p.e. (straight line D1 in the figure), each of the pulse signals G11 and G12 is counted as one pulse without being distinguished from each other. Further, when the threshold of the comparator for the voltage signal is set to, for example, 1.5 p.e. (straight line D2 in the figure), the pulse signal G12 is not detected, and only the pulse signal G11 is counted.

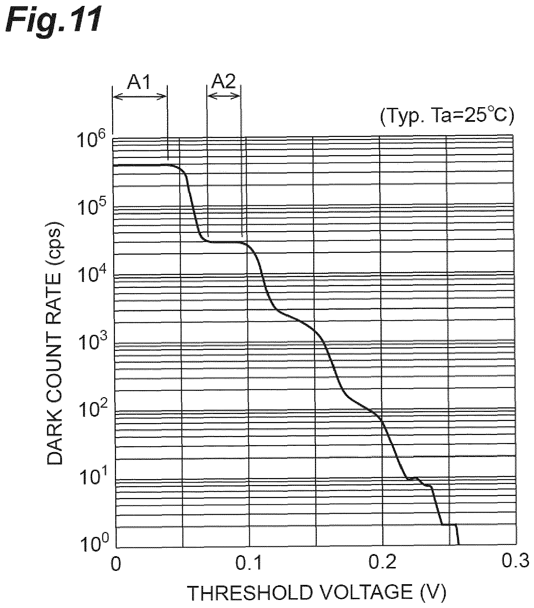

FIG. 11 is a graph showing an example in which a sample is placed in a dark box and the threshold of the comparator is changed to measure a count rate of the spontaneous light (hereinafter, referred to as a dark count rate). In FIG. 11, the vertical axis indicates the dark count rate (unit: cps (counts per second)), and the horizontal axis indicates the threshold (unit: V).

In a range A1 in which the threshold is less than 1.0 (p.e.), pulse signals of all pulse heights are counted, and the dark count rate becomes a high value. Further, in a range A2 in which the threshold is larger than 1.0 (p.e.) and less than 2.0 (p.e.), a pulse signal of a height of 1.0 (p.e.) is not counted, and thus, the dark count rate decreases by one step from the range A1. Thus, the dark count rate decreases stepwise as the threshold increases.

When the dark count rate in the range A1 is set to $N_{0.5p.e.}$ and the dark count rate in the range A2 is set to $N_{1.5p.e.}$, a crosstalk probability representing a degree of crosstalk is calculated by the ratio of $N_{0.5p.e.}$ and $N_{1.5p.e.}$ ($N_{1.5p.e.}$ / $N_{0.5p.e.}$). It can be said that the larger the crosstalk probability, the larger the degree of crosstalk.

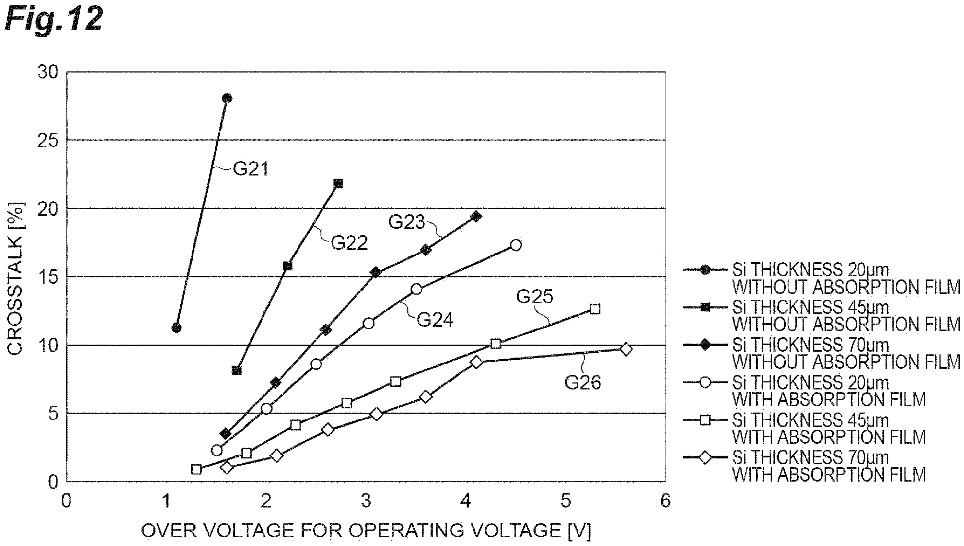

FIG. 12 is a graph showing a relationship between the reverse bias voltage and the crosstalk probability in each sample in the example. In FIG. 12, the vertical axis indicates the crosstalk probability (unit: %), and the horizontal axis indicates the over voltage (unit: V) with respect to the operating voltage. Graphs G21 to G23 in the figure show the case of the above layered structure 100B (that is, without the light absorption film), and graphs G24 to G26 in the figure show the case of the above layered structure 100A (that is, with the light absorption film). Further, the graphs G21 and G24 show the case where the thickness of the Si layer 106 is set to 20 $\mu$m, the graphs G22 and G25 show the case where the thickness of the Si layer 106 is set to 45 $\mu$m, and the graphs G23 and G26 show the case where the thickness of the Si layer 106 is set to 70 $\mu$m.

Referring to FIG 12, it can be seen that the thinner the Si layer 106 is, the larger the crosstalk probability is. This means that the crosstalk is more likely to occur as the semiconductor substrate 16 is thinner. Further, referring to FIG. 12, it can be seen that the crosstalk probability is much lower in the layered structure 100A (with the light absorption film) than in the layered structure 100B (without the light absorption film). This means that, in the present embodiment, the photodetection element 10 includes the light absorption film 13, and thus, the crosstalk can be significantly reduced. In addition, although this result relates to the spontaneous light, it can be considered that the same applies to the detection target light.

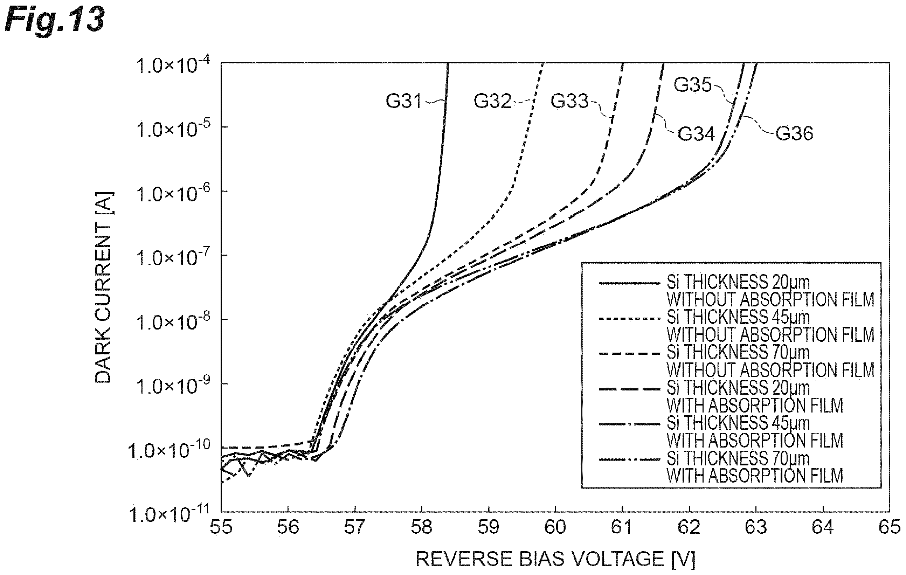

FIG. 13 is a graph showing dark current characteristics caused by the spontaneous light in each sample in the example. In FIG. 13, the vertical axis indicates the magnitude of the dark current (unit: A), and the horizontal axis indicates the reverse bias voltage (unit: V). Graphs G31 to G33 in the figure show the case of the above layered structure 100B (without the light absorption film), and graphs G34 to G36 in the figure show the case of the above layered structure 100A (with the light absorption film). Further, the graphs G31 and G34 show the case where the thickness of the Si layer 106 is set to 20 $\mu$m, the graphs G32 and G35 show the case where the thickness of the Si layer 106 is set to 45 $\mu$m, and the graphs G33 and G36 show the case where the thickness of the Si layer 106 is set to 70 $\mu$m.

Referring to FIG. 13, it can be seen that the thinner the Si layer 106 is, the narrower the range of the usable reverse bias voltage is (the lower the reverse bias voltage when the dark current rapidly increases). This means that the thinner the semiconductor substrate 16 is, the narrower the range of the usable reverse bias voltage is. Further, referring to FIG. 13, it can be seen that in the layered structure 100A (with the light absorption film), the range of the usable reverse bias voltage is wide (the reverse bias voltage when the dark current rapidly increases is large) compared to the layered structure 100B (without the light absorption film).

For example, when the graph G31 is compared with the graph G34, even when the thickness of the Si layer 106 is the same, the dark current increases at a point near 57.5 V in the graph G31, but the dark current increases at a point near 61 V in the graph G34. Therefore, in the graph G34, the range of the usable reverse bias voltage is wider by about +3.5 V than in the graph G31. This means that, in the present embodiment, the photodetection element 10 includes the light absorption film 13, and thus, it is possible to effectively absorb the spontaneous light and expand the range of the usable reverse bias voltage.

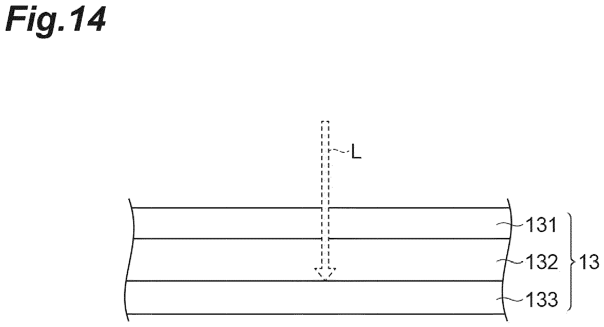

The operation of the light absorption film 13 of the present embodiment will be described in detail. FIG. 14 is a diagram schematically illustrating a cross-sectional configuration of the light absorption film 13.

As described above, the light absorption film 13 has the multi-layer structure including the light absorption layer 131, the resonance layer 132, and the reflection layer 133. A part of the light L reaching the light absorption film 13 is reflected on the surface of the light absorption layer 131, and the remaining part enters the light absorption layer 131. In this case, when the sheet resistance of the light absorption layer 131 is matched with the spatial impedance of the adjacent semiconductor substrate 16, the surface reflectance becomes zero, and all the light L enters the light absorption layer 131.

The light L entering the light absorption layer 131 is gradually absorbed at a ratio calculated based on the extinction coefficient of the light absorption layer 131, and thus, when the light absorption layer 131 is sufficiently thick, most of the light L is absorbed by the light absorption layer 131. However, an increase in thickness of the light absorption layer 131 leads to a decrease in sheet resistance and an increase in surface reflectance of the light absorption layer 131. Therefore, in the present embodiment, the thickness of the light absorption layer 131 is limited to allow a part of the light L to pass through the light absorption layer 131.

A part of the transmitted light L is reflected on the interface between the resonance layer 132 and the light absorption layer 131, and returns to the light absorption layer 131. Hereinafter, the above reflected light is referred to as first reflected light. When the light absorption layer 131 is made of metal and the resonance layer 132 is made of dielectric, the first reflected light does not include a phase shift of $\pi$ (rad) because the impedance of the resonance layer 132 is larger than the impedance of the light absorption layer 131 (in other words, the refractive index of the resonance layer 132 is smaller than the refractive index of the light absorption layer 131).

Further, the remaining part of the light L passes through the interface and enters the resonance layer 132. The light L that has entered the resonance layer 132 reaches the interface between the resonance layer 132 and the reflection layer 133 almost without being attenuated, and is totally reflected at the interface. Hereinafter, the above reflected light is referred to as second reflected light. The second reflected light travels inside the resonance layer 132 again toward the light absorption layer 131. The impedance of the reflection layer 133 is close to 0 $\Omega$ (in other words, the refractive index is close to infinity), and therefore, the second reflected light includes a phase shift of $\pi$ (rad).

When the phase difference between the second reflected light and the first reflected light is $\pi$ (rad) when the second reflected light reaches the light absorption layer 131, they cancel each other out. For this purpose, the optical thickness of the resonance layer 132 (in other words, the optical distance between the light absorption layer 131 and the reflection layer 133) is preferably 1/4 of the wavelength of the light L. Further, the electric field amplitude of the first reflected light and the electric field amplitude of the second reflected light are not exactly the same, and therefore, they do not completely cancel each other out, and a part of the reflected light is incident on the light absorption layer 131. The reflected light incident on the light absorption layer 131 is absorbed by the light absorption layer 131. Further, a part of the second reflected light remains inside the resonance layer 132 and repeats multiple reflection, but is gradually absorbed by the light absorption layer 131. Thus, most of the light L is absorbed by the light absorption layer 131.

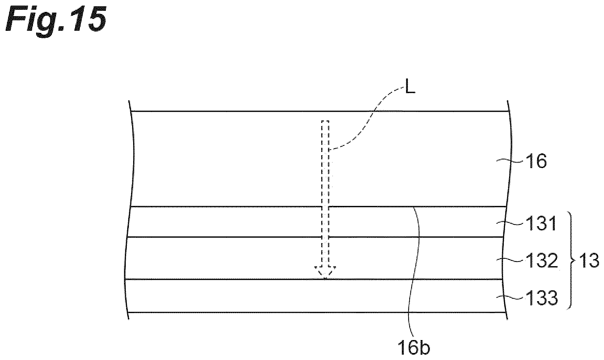

A design example of the light absorption film 13 will be described. FIG. 15 is a diagram schematically illustrating a configuration in which the light absorption film 13 is disposed on the rear surface 16b of the semiconductor substrate 16.

In the present embodiment, as illustrated in FIG. 15, the light absorption layer 131 of the light absorption film 13 is in contact with the semiconductor substrate 16. In addition, the semiconductor substrate 16 is assumed to be made of Si or InP. The wavelength of the light L is assumed to be 1.55 $\mu$m. It is assumed that the light absorption layer 131 is made of WSi, the resonance layer 132 is made of $SiO_2$, and the reflection layer 133 is made of Al.

The characteristic impedance of air is 377 Ω, and the refractive index of Si and InP is about 3.5, and thus, the characteristic impedance of the semiconductor substrate 16 is 377 Ω / 3.5 = 108 Ω. Further, the specific resistance of tungsten silicide ($WSi_2$) is 2.48 × $10^{-4}$ Ω·cm. Therefore, a preferred thickness t of the light absorption layer 131 is calculated as follows.

[Formula 1]

$$t = \frac{2.48 \times 10^{-4} \Omega \cdot cm}{108 \Omega} = 23 \times 10^{-7} \, cm = 23 nm$$

Further, the specific refractive index of $SiO_2$ is 1.48, and thus, a preferred thickness of the resonance layer 132 is calculated as 1.55 μm / 1.48 / 4 = 262 nm. Further, the specific resistance of Al is 2.65 × $10^{-6}$ Ω·cm, and thus, the sheet resistance is 0.0265 Ω by setting the reflection layer 133 to have a sufficient thickness of, for example, 1 μm. The impedance of $SiO_2$ is as follows.

[Formula 2]

$$\frac{377 \Omega}{1.48} = 255 \Omega$$

Therefore, the reflection coefficient at the interface between the resonance layer 132 and the reflection layer 133 is 0.998.

According to the procedure described above, it is also easy to design the light absorption film 13 according to the wavelength $\lambda_1$ of the detection target light or the wavelength $\lambda_2$ of the spontaneous light. The following Table 1 is a table showing a design example of the light absorption film 13 in the case where the wavelength $\lambda_1$ of the detection target light is set to 600 nm, 800 nm, and 1000 nm. Further, the following Table 2 is a table showing a design example of the light absorption film 13 in the case where the wavelength $\lambda_2$ of the spontaneous light is within a range of 700 nm to 1100 nm.

[Table 1]

| detection target light wavelength (nm) | light absorption layer | | resonance layer | | reflection layer | |
|---|---|---|---|---|---|---|
| | material | thickness (nm) | material | thickness (nm) | material | thickness (nm) |
| 600 | $WSi_2$ | 23 | $SiO_2$ | 207 | Al | 1000 |
| 800 | $WSi_2$ | 23 | $SiO_2$ | 292 | Al | 1000 |
| 1000 | $WSi_2$ | 23 | $SiO_2$ | 380 | Al | 1000 |

[Table 2]

| spontaneous light wavelength (nm) | light absorption layer | | resonance layer | | reflection layer | |
|---|---|---|---|---|---|---|
| | material | thickness (nm) | material | thickness (nm) | material | thickness (nm) |
| 700 - 1100 | $WSi_2$ | 23 | $SiO_2$ | 60 | Al | 1000 |

In addition, in the design examples described above, it is assumed that the light L is incident from a direction perpendicular to the surface of the light absorption film 13 (in other words, the thickness direction of the light absorption film 13), however, when the light L is incident from a direction inclined with respect to the surface of the light absorption film 13, an incident angle of the light L may be added to the above design. That is, a propagation angle of the light in each of the layers 131 to 133 may be calculated from the refractive index of each of the layers 131 to 133, and the thickness of each of the layers 131 to 133 may be set in consideration of the propagation angle.

(modification)

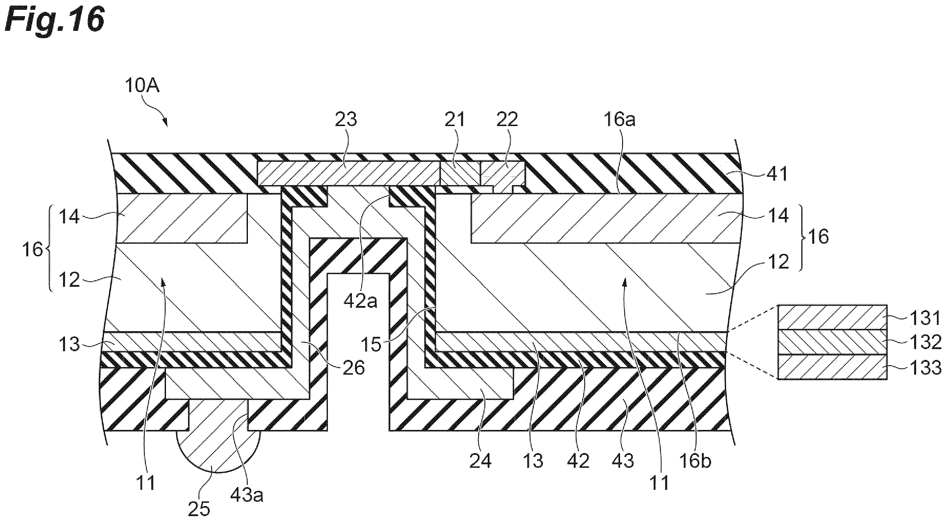

FIG. 16 is a partial cross-sectional view illustrating a configuration of a photodetection element 10A according to a first modification of the above embodiment. The photodetection element 10A is different from the above photodetection element 10 in that it does not include the glass substrate 31 and the optical adhesive 32, and is identical to the photodetection element 10 in other respects. Even with the above configuration, the same function and effect as those of the above embodiment can be achieved.

Further, when the glass substrate 31 is not provided as in the present modification, light loss (absorption and reflection) due to the glass substrate 31 and the optical adhesive 32 can be avoided, and photodetection efficiency can be increased. In addition, generation of outgas from the optical adhesive 32 can be avoided. Furthermore, it is possible to mount an additional optical component such as a scintillator or a microlens directly on the light incident surface of the photodetection element.

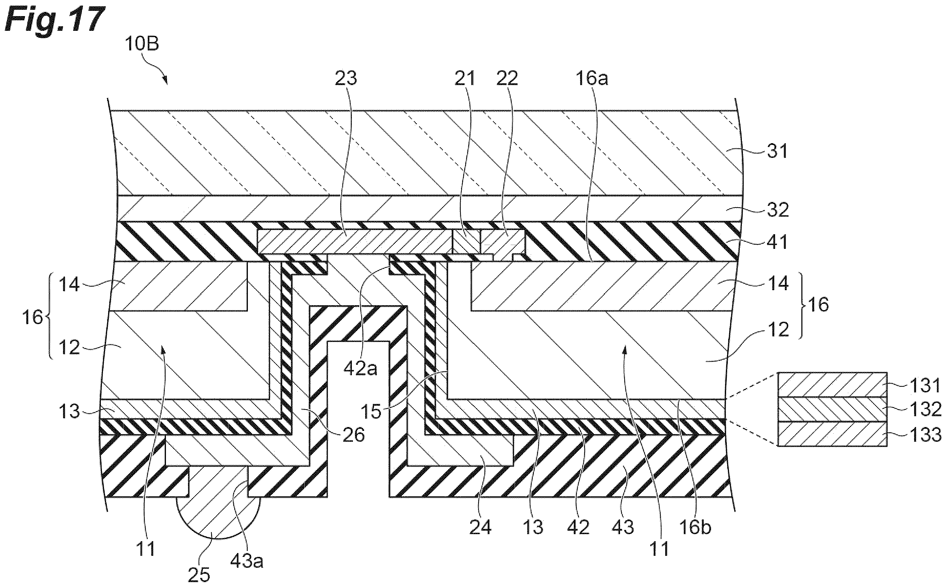

FIG. 17 is a partial cross-sectional view illustrating a configuration of a photodetection element 10B according to a second modification of the above embodiment. The photodetection element 10B is different from the above photodetection element 10 in that the light absorption film 13 is formed on the inner side surface and the bottom surface of the through hole 15 in addition to on the rear surface 16b, and is identical to the photodetection element 10 in other respects. In this case, the insulating film 42 and the through electrode 26 are disposed in the through hole 15 via the light absorption film 13.

With the above configuration, reflection of light on the inner side surface of the through hole 15 can be suppressed in addition to the rear surface 16b, and thus, it is possible to further suppress a decrease in temporal resolution, and it is possible to further reduce crosstalk between adjacent cells. When forming the photodetection element 10B of the present modification, it is preferable to form the light absorption film 13 after forming the through hole 15. In addition, when the light absorption film 13 is formed only on the rear surface 16b and is not formed on the inner side surface and the bottom surface of the through hole 15 as in the above embodiment, there is an advantage in that a manufacturing process may be facilitated, and the number of processes may be reduced to reduce cost.

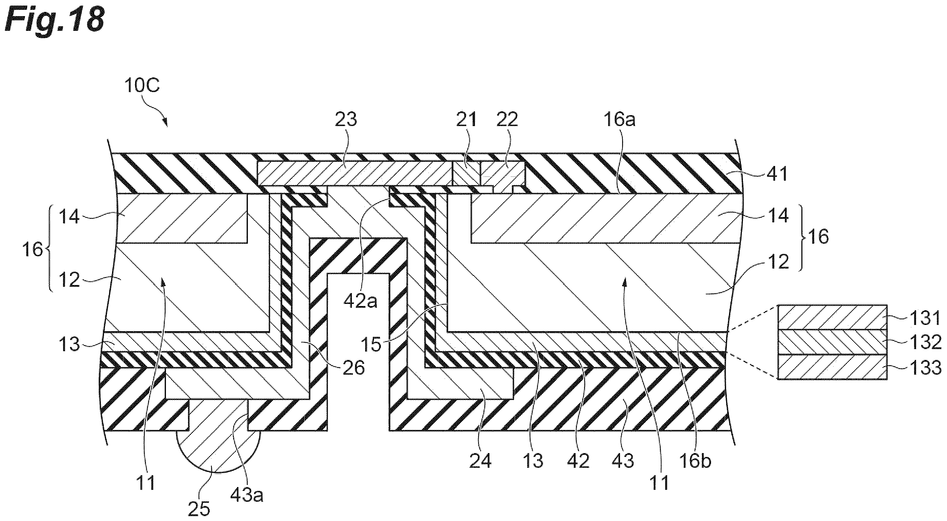

FIG. 18 is a partial cross-sectional view illustrating a configuration of a photodetection element 10C according to a third modification of the above embodiment. The photodetection element 10C is different from the above photodetection element 10B in that it does not include the glass substrate 31 and the optical adhesive 32, and is identical to the photodetection element 10B in other respects. With the above configuration, the same function and effect as those of the first modification and the second modification can be achieved.

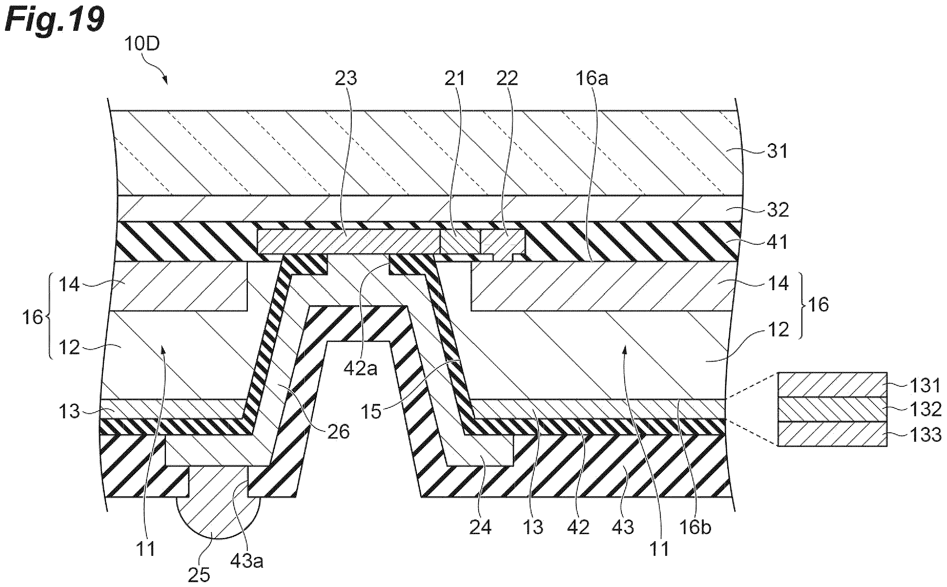

FIG. 19 is a partial cross-sectional view illustrating a configuration of a photodetection element 10D according to a fourth modification of the above embodiment. The photodetection element 10D is different from the above photodetection element 10 in that the inner side surface of the through hole 15 is inclined with respect to the thickness direction of the semiconductor substrate 16 (that is, the direction perpendicular to the principal surface 16a and the rear surface 16b), and is identical to the photodetection element 10 in other respects. In this case, an inner diameter of the through hole 15 increases from the principal surface 16a toward the rear surface 16b. Even with the above configuration, the same function and effect as those of the above embodiment can be achieved.

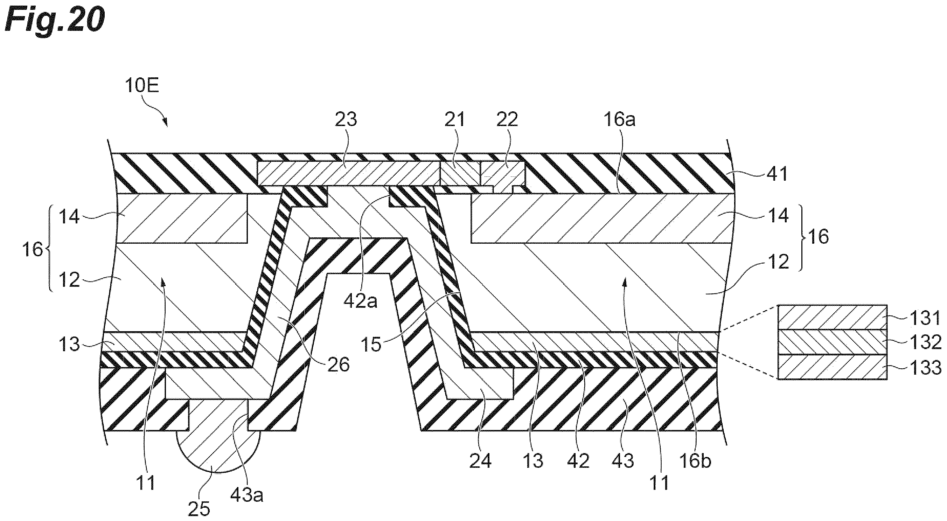

FIG. 20 is a partial cross-sectional view illustrating a configuration of a photodetection element 10E according to a fifth modification of the above embodiment. The photodetection element 10E is different from the above photodetection element 10D in that it does not include the glass substrate 31 and the optical adhesive 32, and is identical to the photodetection element 10D in other respects. Even with the above configuration, the same function and effect as those of the above embodiment can be achieved. Further, since the glass substrate 31 is not provided, the same function and effect as those of the first modification can be achieved.

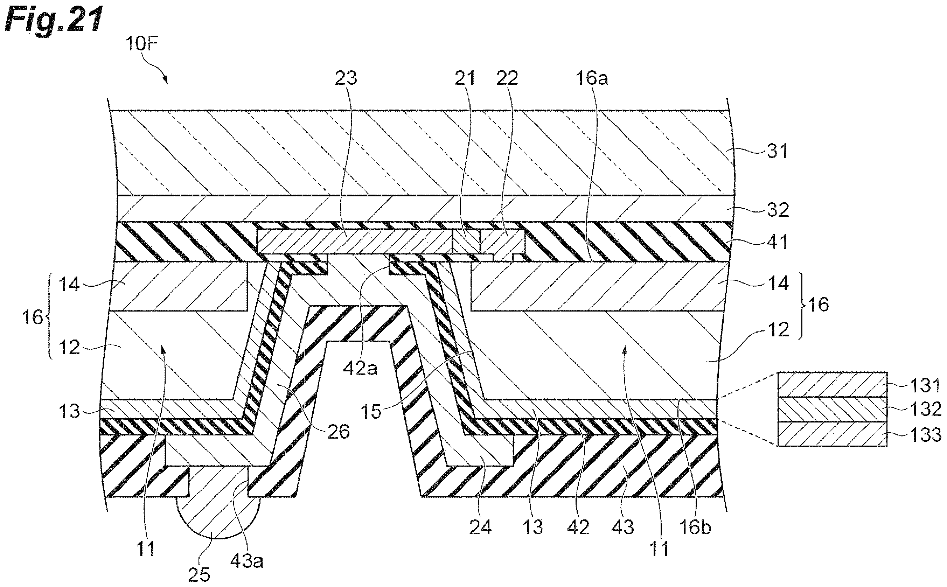

FIG. 21 is a partial cross-sectional view illustrating a configuration of a photodetection element 10F according to a sixth modification of the above embodiment. The photodetection element 10F is different from the above photodetection element 10D in that the light absorption film 13 is formed on the inner side surface and the bottom surface of the through hole 15 in addition to on the rear surface 16b, and is identical to the photodetection element 10D in other respects. In this case, the same function and effect as those of the second modification can be achieved.

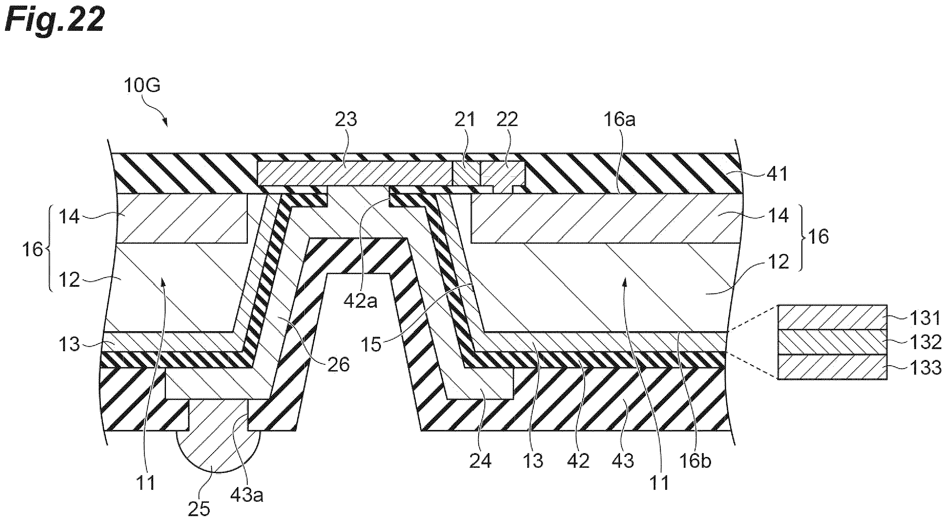

FIG. 22 is a partial cross-sectional view illustrating a configuration of a photodetection element 10G according to a seventh modification of the above embodiment. The photodetection element 10G is different from the above photodetection element 10F in that it does not include the glass substrate 31 and the optical adhesive 32, and is identical to the photodetection element 10F in other respects. According to the above configuration, the same function and effect as those of the fifth modification and the sixth modification can be achieved.

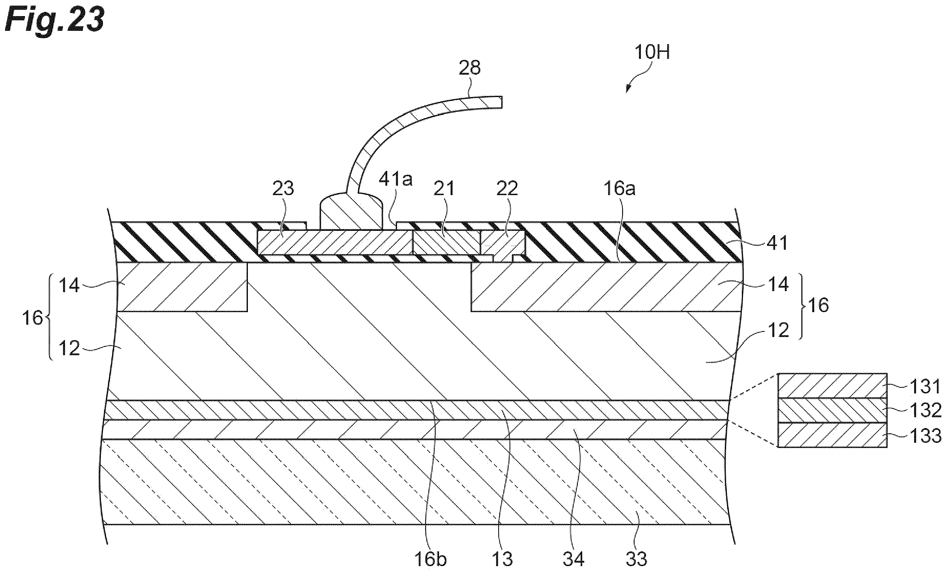

FIG. 23 is a partial cross-sectional view illustrating a configuration of a photodetection element 10H according to an eighth modification of the above embodiment. The photodetection element 10H includes a bonding wire 28 instead of the bump electrode 25 and the through electrode 26 of the above embodiment, and further, includes a glass substrate 33 and an optical adhesive 34 instead of the glass substrate 31 and the optical adhesive 32 of the above embodiment.

Specifically, the through hole 15 is not formed in the semiconductor substrate 16, and the electrode 23 is exposed through an opening 41a formed on an upper surface of the insulating film 41. The bonding wire 28 is provided for each of the plurality of cells. Further, one end of the bonding wire 28 is connected to a portion of the electrode 23 exposed in the opening 41a. In addition, the other end of the bonding wire 28 is connected to a circuit substrate, which is not shown, having the same circuit as that of the mounting substrate 35 of the above embodiment.

The light absorption film 13 is formed over the entire rear surface 16b of the semiconductor substrate 16, and the glass substrate 33 is bonded to the surface of the light absorption film 13 on the side opposite to the semiconductor substrate 16 (that is, the surface of the reflection layer 133) via the optical adhesive 34. Even with the above configuration, the same function and effect as those of the above embodiment can be achieved. Further, since it is not necessary to form the through electrode 26, a manufacturing process may be facilitated, and the number of processes may be reduced to reduce cost.

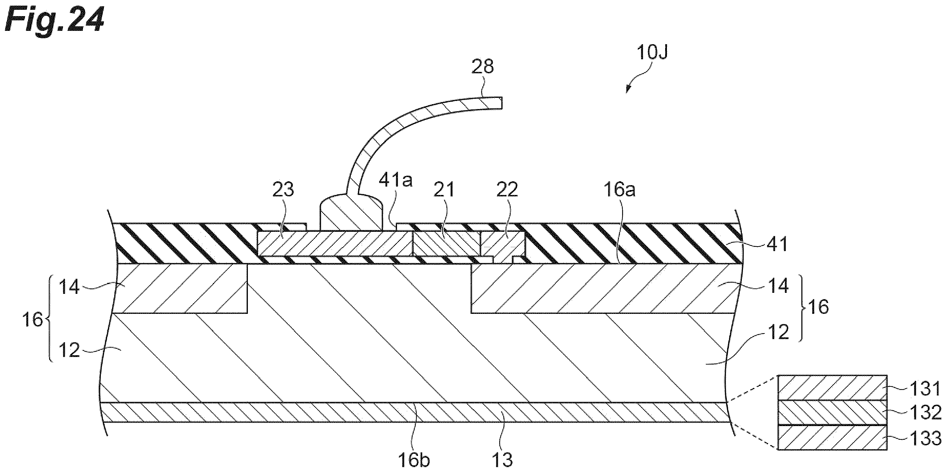

FIG. 24 is a partial cross-sectional view illustrating a configuration of a photodetection element 10J according to a ninth modification of the above embodiment. The photodetection element 10J is different from the above photodetection element 10H in that it does not include the glass substrate 33 and the optical adhesive 34, and is identical to the photodetection element 10H in other respects. Even with the above configuration, the same function and effect as those of the eighth modification can be achieved. Further, since the glass substrate 33 is not provided, the same function and effect as those of the first modification can be obtained.

The semiconductor photodetection element is not limited to the embodiments and configuration examples described above, and various modifications are possible.

Although one quenching resistor 21 is electrically connected to one through electrode 26, it is not limited thereto. A plurality of quenching resistors (for example, four quenching resistors) 21 may be electrically connected to one through electrode 26. In this case, the through electrode 26 is shared by the cells, and the number of through electrodes 26 formed in the semiconductor substrate 16 can be reduced. Thus, it is possible to suppress a decrease in mechanical strength of the semiconductor substrate 16. The number of quenching resistors electrically connected to one through electrode 26 is not limited to "4", and may be "3" or less, or "5" or more.

When the plurality of quenching resistors 21 are electrically connected to one through electrode 26, it is preferable that the wiring distance from each photodetection region 11 to the through electrode 26 via the corresponding quenching resistor 21 is equal. In this case, even in the configuration in which the through electrode 26 is shared by the cells, it is possible to prevent temporal resolution from decreasing.

The shape of the semiconductor region 14 is not limited to the above-described shape, and may be another shape (for example, a circular shape). Further, the number (the number of rows and the number of columns) and arrangement of the photodetection regions 11 are not limited to those described above.

The photodetection element 10 includes the plurality of photodetection regions 11, but it is not limited thereto. The photodetection element may include a single photodetection region 11. Even in the above case, the effect of suppressing a decrease in temporal resolution can be achieved.

The photodetection device 1A has the configuration of collectively (in a lump) outputting output currents from the plurality of photodetection regions 11, but it is not limited thereto. The photodetection element may be applied to a photodetection device which individually outputs an output current from a plurality of photodetection regions (pixels) 11 for each photodetection region 11. The photodetection device of the above configuration can be used as an imaging device such as a CCD. In this case, a "cell" in the above embodiment is read as a "pixel", and the photodetection element can reduce crosstalk between adjacent pixels.

The semiconductor photodetection element of the above embodiment includes a semiconductor substrate having a principal surface on which detection target light is incident and a rear surface opposite to the principal surface, and including one or a plurality of photodetection regions on the principal surface side each for generating a charge in an amount according to a light intensity of the detection target light; and a light absorption film provided on the rear surface of the semiconductor substrate, and the light absorption film has a multi-layer structure including a reflection layer being a metal layer, a resonance layer provided between the reflection layer and the semiconductor substrate, and a light absorption layer provided between the resonance layer and the semiconductor substrate, and in at least one of a wavelength of the detection target light and a wavelength of spontaneous light generated in the photodetection region, a light transmittance inside the resonance layer is larger than a light transmittance inside the light absorption layer, and a light reflectance on a surface of the reflection layer is larger than a light reflectance on a surface of the resonance layer.

In the above semiconductor photodetection element, an optical thickness of the resonance layer may be within a range of $\pm 20\%$ centered on an integer multiple of one of 1/4 of the wavelength of the detection target light and 1/4 of the wavelength of the spontaneous light.

In this case, a phase of the light reflected on the interface between the light absorption layer and the resonance layer and a phase of the light reflected on the interface between the resonance layer and the reflection layer are shifted from each other by nearly $\pi$ (rad), and thus, these cancel each other out. Therefore, the absorption efficiency (extinction efficiency) of the light absorption film can be further increased.

In the above semiconductor photodetection element, each of the one or plurality of photodetection regions may be an avalanche photodiode or a p-n junction type photodiode. For example in the above case, a charge in an amount according to the light intensity of the detection target light can be generated in the photodetection region.

Further, in particular, when the photodetection region is the avalanche photodiode, the spontaneous light is generated in the photodetection region. In the above semiconductor photodetection element, crosstalk due to the spontaneous light generated in the photodetection region can also be reduced. Therefore, the above semiconductor photodetection element is particularly effective when the photodetection region is the avalanche photodiode.

The above semiconductor photodetection element may further include a through electrode provided between the principal surface and the rear surface, and having one end on the principal surface side electrically connected to the photodetection region. In this case, a wiring substrate or the like can be disposed on the rear surface opposite to the principal surface on which the light is incident, and thus, even when a large number of photodetection regions are arranged on the principal surface, the charge (output current) from each photodetection region can be easily extracted.

Further, in order to improve the ease of forming the through electrode, it is preferable to thin the semiconductor substrate. However, in this case, a distance between the light incident surface (principal surface) and the rear surface of the semiconductor substrate becomes small, and thus, temporal resolution is likely to be reduced and crosstalk between adjacent pixels (adjacent cells) is likely to occur. According to the above semiconductor photodetection element, it is possible to suppress a decrease in temporal resolution and reduce crosstalk between the adjacent pixels (adjacent cells), and thus, it is particularly effective in the case where the through electrode is provided in the semiconductor substrate.

In the above semiconductor photodetection element, the light absorption layer may mainly contain tungsten silicide, and the resonance layer may mainly contain $SiO_2$. In this case, the light absorption film having high absorption efficiency can be realized.

Industrial Applicability

The present invention can be used as a semiconductor photodetection element capable of reducing reflection of light on a rear surface of a semiconductor substrate.

Reference Signs List

1A- photodetection device, 10, 10A- 10H, 10J - photodetection element, 11 - photodetection region, 12 - semiconductor region, 13 - light absorption film, 14 - semiconductor region, 15 - through hole, 16 - semiconductor substrate, 16a - principal surface, 16b - rear surface, 21 - quenching resistor, 22, 23, 24, 27 - electrode, 25 - bump electrode, 26 - through electrode, 28 - bonding wire, 31 - glass substrate, 31a - principal surface, 31b - rear surface, 32 - optical adhesive, 33 - glass substrate, 34 - optical adhesive, 35 - mounting substrate, 35a - principal surface, 36 - signal processing unit, 41, 42 - insulating film, 41a, 42a - opening, 43, 44 - passivation film, 43a, 44a - opening, 100A, 100B - layered structure, 101 - support glass, 102 - bonding resin, 103 - alloy layer, 104 - $SiO_2$ layer, 105 - WSi layer, 106 - Si layer, 108 - resin insulating layer, 110 - semiconductor region, 131 - light absorption layer, 132 - resonance layer, 133 - reflection layer, L - light, V1 - negative potential, V2 - positive potential.

**Claims**

1. A semiconductor photodetection element comprising:

    a semiconductor substrate having a principal surface on which detection target light is incident and a rear surface opposite to the principal surface, and including one or a plurality of photodetection regions on the principal surface side each for generating a charge in an amount according to a light intensity of the detection target light; and
    a light absorption film provided on the rear surface of the semiconductor substrate, wherein
    the light absorption film has a multi-layer structure including a reflection layer being a metal layer, a resonance layer provided between the reflection layer and the semiconductor substrate, and a light absorption layer provided between the resonance layer and the semiconductor substrate, and
    in at least one of a wavelength of the detection target light and a wavelength of spontaneous light generated in the photodetection region, a light transmittance inside the resonance layer is larger than a light transmittance inside the light absorption layer, and a light reflectance on a surface of the reflection layer is larger than a light reflectance on a surface of the resonance layer.

2. The semiconductor photodetection element according to Claim 1, wherein an optical thickness of the resonance layer is within a range of $\pm20\%$ centered on an integer multiple of one of 1/4 of the wavelength of the detection target light and 1/4 of the wavelength of the spontaneous light.

3. The semiconductor photodetection element according to Claim 1 or 2, wherein each of the one or plurality of photodetection regions is an avalanche photodiode or a p-n junction type photodiode.

4. The semiconductor photodetection element according to any one of Claims 1 to 3, further comprising a through electrode provided between the principal surface and the rear surface, and having one end on the principal surface side electrically connected to the photodetection region.

5. The semiconductor photodetection element according to any one of Claims 1 to 4, wherein the light absorption layer mainly contains tungsten silicide, and the resonance layer mainly contains $SiO_2$.

*Fig.1*

# Fig.2

Fig.3

# Fig.4

(a)

(b)

(c)

# Fig.5

(a)

(b)

(c)

# Fig.6

(a)

(b)

# Fig.7

(a)

(b)

## *Fig.8*

100A

110    107

| 110 | p-Si | p-Si | p-Si | 110 |

| n-Si | ~106 |

| WSi2 | ~105 |

| SiO2 | ~104 |

| AlCu | ~103 |

| BONDING RESIN | ~102 |

| SUPPORT GLASS | ~101 |

## Fig.9

100B

110    107

110 — | p-Si | p-Si ~110 | p-Si | — 110

n-Si    ~106

INSULATING RESIN    ~108

AlCu    ~103

BONDING RESIN    ~102

SUPPORT GLASS    ~101

Fig.10

## Fig.11

# Fig.12

Legend:
- Si THICKNESS 20μm WITHOUT ABSORPTION FILM
- Si THICKNESS 45μm WITHOUT ABSORPTION FILM
- Si THICKNESS 70μm WITHOUT ABSORPTION FILM
- Si THICKNESS 20μm WITH ABSORPTION FILM
- Si THICKNESS 45μm WITH ABSORPTION FILM
- Si THICKNESS 70μm WITH ABSORPTION FILM

# Fig.13

EP 4 131 431 A1

*Fig.14*

**Fig.15**

# Fig.16

EP 4 131 431 A1

Fig.17

EP 4 131 431 A1

# Fig.18

EP 4 131 431 A1

Fig.19

*Fig.20*

EP 4 131 431 A1

EP 4 131 431 A1

**Fig.21**

Fig.22

EP 4 131 431 A1

**Fig.23**

EP 4 131 431 A1

# Fig.24

EP 4 131 431 A1

**INTERNATIONAL SEARCH REPORT**

| International application No. |
| --- |
| PCT/JP2021/018677 |

A. CLASSIFICATION OF SUBJECT MATTER
Int.Cl. H01L31/107(2006.01)i, H01L27/146(2006.01)i
FI: H01L31/10B, H01L27/146D, H01L27/146A

According to International Patent Classification (IPC) or to both national classification and IPC

B. FIELDS SEARCHED

Minimum documentation searched (classification system followed by classification symbols)
Int.Cl. H01L31/08-31/119, H01L27/146-27/148

Documentation searched other than minimum documentation to the extent that such documents are included in the fields searched
Published examined utility model applications of Japan      1922–1996
Published unexamined utility model applications of Japan    1971–2021
Registered utility model specifications of Japan            1996–2021
Published registered utility model applications of Japan    1994–2021

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| A | US 2019/0027527 A1 (UNIVERSITY OF ZAGREB, FAQJLTY OF ELECTRICAL ENGINEERING AND COMPUTING) 24 January 2019 (2019-01-24) | 1–5 |
| A | US 9395182 B1 (THE BOEING COMPANY) 19 July 2016 (2016-07-19) | 1–5 |
| A | US 2019/0165026 A1 (TAIWAN SEMICONDUCTOR MANUFACTURING CO., LTD.) 30 May 2019 (2019-05-30) | 1–5 |
| A | JP 2009-206309 A (MITSUBISHI ELECTRIC CORPORATION) 10 September 2009 (2009-09-10) | 1–5 |
| A | JP 2010-21337 A (MITSUBISHI ELECTRIC CORPORATION) 28 January 2010 (2010-01-28) | 1–5 |
| A | WO 2019/221104 A1 (SONY SEMICONDUCTOR SOLUTIONS CORP.) 21 November 2019 (2019-11-21) | 1–5 |

☐ Further documents are listed in the continuation of Box C.  ☒ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 12 July 2021 | 20 July 2021 |

| Name and mailing address of the ISA/ Japan Patent Office 3-4-3, Kasumigaseki, Chiyoda-ku, Tokyo 100-8915, Japan | Authorized officer |
| | Telephone No. |

Form PCT/ISA/210 (second sheet) (January 2015)

| INTERNATIONAL SEARCH REPORT | International application No. |
|---|---|
| Information on patent family members | PCT/JP2021/018677 |

```
US 2019/0027527 A1 24 January 2019      (Family: none)

US 9395182 B1        19 July 2016       (Family: none)

US 2019/0165026 A1 30 May 2019          CN 109841641 A
                                        TW 201926733 A

JP 2009-206309 A    10 September 2009   US 2009/0218595 A1
                                        CN 101521245 A

JP 2010-21337 A     28 January 2010     US 2010/0006967 A1
                                        CN 101626043 A

WO 2019/221104 A1   21 November 2019    JP 2019-200383 A
                                        US 2021/0191019 A1
```

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007305675 A

- US 20130099100